## Europäisches Patentamt

## European Patent Office

## Office européen des brevets

(11) Veröffentlichungsnummer: **0 016 768 B1**

# EUROPÄISCHE PATENTSCHRIFT

(45) Veröffentlichungstag der Patentschrift:
**27.10.82**

(21) Anmeldenummer: **79900486.6**

(22) Anmeldetag: **16.05.79**

(86) Internationale Anmeldenummer:
**PCT/CH 79/00068**

(87) Internationale Veröffentlichungsnummer:
**WO 80/00116 (24.01.80** Gazette 80/2)

(51) Int. Cl.³: **H 01 L 23/04,** H 01 L 21/60,
H 01 L 23/10

(54) **HALBLEITERBAUELEMENT MIT ISOLIERGEHÄUSE.**

(30) Priorität: **12.06.78 DE 2825682**

(43) Veröffentlichungstag der Anmeldung:
**15.10.80 Patentblatt 80/21**

(45) Bekanntmachung des Hinweises auf die Patenterteilung:
**27.10.82 Patentblatt 82/43**

(84) Benannte Vertragsstaaten:
**CH FR GB**

(56) Entgegenhaltungen:
**DE-A-1 439 132**
**DE-A-2 654 532**
**FR-A-2 335 955**
**GB-A-1 191 232**
**US-A-3 443 168**
**US-A-4 021 839**

(73) Patentinhaber: **BBC Aktiengesellschaft Brown, Boveri & Cie., CH-5401 Baden (CH)**

(72) Erfinder: **EISELE, Dieter, Edisonstrasse 10, D-6840 Lampertheim (DE)**
Erfinder: **KMITTA, Hubert, Brombergerstrasse 13, D-6944 Hemsbach (DE)**

(74) Vertreter: **Kempe, Wolfgang, Dr., Postfach 1273, D-6800 Mannheim 1 (DE)**

## Halbleiterbauelement mit Isoliergehäuse

Die Erfindung betrifft ein Halbleiterbauelement mit einem scheibenförmigen, mindestens einen pn-Übergang aufweisenden Halbleiterkörper (10), welcher an jeder seiner beiden Hauptoberflächen über zwischengelegte Elektrodenteile, dabei insbesondere eine duktile Elektrode (12, 13), und über einen vorzugsweise aus Kupfer bestehenden Druckkontaktkörper (21, 22) thermisch und elektrisch druckkontaktierbar ist, mit einem die Ränder des Halbleiterkörpers (10) und der Druckkontaktkörper (21, 22) umschließenden, zylinderringförmigen Isoliergehäuse (29) sowie mit elastischen Dichtungsringen (23, 24) zur Abdichtung des Spaltes zwischen den Druckkontaktkörpern (21, 22) und dem Isoliergehäuse (29). Bevorzugt handelt es sich um Leistungsthyristoren für Ströme bis mindestens 2000 A, für höchstzulässige, periodische Spitzensperrspannungen in Vorwärts- und Rückwärtsrichtung bis mindestens 1800 V und für Frequenzen bis mindestens 1500 Hz.

Ein derartiges Halbleiterbauelement ist aus der DE-A-2 654 532 bekannt. Bei dieser bekannten Konstruktion werden zur Abdichtung zwischen den Druckkontaktkörpern und dem Gehäuse entweder ein oder zwei Dichtungsringe verwendet. Für den Fall, daß ein Dichtungsring verwendet wird, liegt dieser direkt zwischen den beiden Druckkontaktkörpern aus Kupfer; für den Fall, daß zwei Dichtungsringe verwendet werden, liegen diese zwischen je einem Druckkontaktkörper und einem umlaufenden, ringförmigen Vorsprung an der Innenwandung des Isoliergehäuses. In beiden Fällen erfolgt die mechanische Halterung zwischen den Druckkontaktkörpern und dem Isoliergehäuse durch Sprengringe aus Federstahl, die in in der Innenmantelfläche des Isolierstoffgehäuses eingedrehte Nuten eingesetzt sind. .

Aus der FR-A-2 335 955 ist ein Halbleiterbauelement bekannt, dessen Isoliergehäuse aus Keramik besteht. Die aus Kupfer bestehenden Druckkontaktscheiben sind über ringförmige elastische Bleche aus einer Nickel-Eisen-Legierung vakuumdicht mit den Stirnflächen des Isoliergehäuses verbunden. Im Inneren des Gehäuses ist die Halbleiterscheibe in Sandwich-Technik zwischen zwei napfförmige Silberelektroden eingelegt. Die Napfränder sind den Hauptoberflächen der Halbleiterscheibe abgewandt und umfassen die Druckkontaktkörper.

Eine vergleichbare Anordnung ist auch bekannt aus der DE-A-2 039 806. Derartige Halbleiterbauelemente sind erst dann voll funktionsfähig, wenn sie mittels einer äußeren Spannvorrichtung (BBC-Druckschrift Nr. D HS 70467 D von 1977 »Kühlung und Montage von Leistungs-Halbleiterbauelemente«) unter Druck gesetzt werden.

Ein derartiges Halbleiterbauelement muß trotz der hohen äußeren Spannkräfte und trotz der hohen thermischen Wechsellastbeanspruchung infolge des Ein-Ausschaltbetriebs eine über lange Zeit gleichbleibende Kühlung des Halbleiterkörpers sowie eine gute Abdichtung des Gehäuse-Innenraums selbst gegen aggressive Medien gewährleisten.

Der vorliegenden Erfindung liegt die Aufgabe zugrunde, eine erheblich vereinfachte Gehäusekonstruktion anzugeben, die den Innenraum des Halbleiterbauelements, in dem sich der Halbleiterkörper befindet, gegen den Außenraum sicher abdichtet und über einen Temperaturbereich von etwa 200 K mechanisch stabil und dicht ist, so daß eine Störung der elektrischen Eigenschaften ausgeschlossen ist.

Diese Aufgabe wird dadurch gelöst, daß jeder der beiden Druckkontaktkörper in seiner Randseite eine umlaufende Ausnehmung besitzt, in der sich je ein den Druckkontaktkörper dicht umfassender, elastischer Dichtungsring befindet, der an der Innenwand des Isoliergehäuses dichtend anliegt, und daß die mit dem gleichzeitig als elastischer Puffer wirkenden Dichtungsring versehenen Druckkontaktkörper in ihrem in das Isoliergehäuse eingesetzten Zustand das Gehäuse des Halbleiterbauelements komplettieren.

Die mit dieser Dichtringtechnik erreichte Dichtung unter Flächenanlage, wobei eine entsprechende Passung zwischen den zusammenwirkenden Teilen vorauszusetzen ist, läßt eine hohe Temperaturwechselbeanspruchung zu, obwohl das Isoliergehäuse einen anderen Ausdehnungskoeffizienten besitzt als die vorzugsweise aus Kupfer bestehenden Druckkontaktkörper. Die elastischen Dichtungsringe dienen nicht nur als Dichtung, sondern auch als elastischer Puffer zwischen Druckkontaktkörper und Isoliergehäuse. Eine zusätzliche mechanische Halterung, wie sie bei den bekannten Halbleiterbauelementen mit Dichtungsringen üblich ist, ist nicht vorgesehen.

Als Dichtungsringe können vorteilhaft aus dem Maschinenbau bekannte Wellendichtringe aus Naturkautschuk-Vulkanisaten oder aus gummiähnlichen Kunststoffen, vorzugsweise auf der Basis von Neoprenen, Thioplasten oder Siliconen verwendet werden. Das Isoliergehäuse kann in an sich bekannter Weise aus Aluminiumoxidkeramik bestehen. Zur weiteren Verbilligung des Gehäuses kann man jedoch auch Steatite oder glasfaserverstärkte Epoxidmassen wählen. Die vorgenannten Werkstoffkombinationen für die Druckkontaktkörper und das Isoliergehäuse sind wie beschrieben wegen der Dichtringtechnik möglich.

Gemäß einer vorteilhaften Weiterbildung besitzt das Isoliergehäuse an seiner Innenwand oben und unten Fasen mit etwas größerem Durchmesser als die Innenwand selbst. Diese Fasen erleichtern das Einsetzen der Druckkontaktkörper mit den aufgezogenen Dichtungsringen.

Vorzugsweise sind die Druckkontaktkörper an ihren den Halbleiterkörpern zugewandten Seiten mit Zentriereinrichtungen versehen. Dies dient insbesondere der Drucksymmetrierung bezüglich der zur Scheibenebene des Halbleiterkörpers senkrecht verlaufenden Mittelachse.

Bei einer Ausführung des Halbleiterbauelementes ähnlich der Anordnung gemäß der DE-C-2 039 806 mit zwischengelegten napfförmigen duktilen Elektroden, deren hochstehende Napfränder den Druckkontaktkörpern zugewandt sind, weist jeweils der Druckkontaktkörper einen Tisch als Zentrierung auf, der vom Napfrand umfaßt ist. Dabei kann zur besseren Anpassung der Wärmeausdehnungskoeffizienten zusätzlich eine Ronde, vorzugsweise aus Molybdän, in die napfförmige Elektrode eingesetzt sein. — Eine exakt zentrierte Anordnung von Halbleiterkörper, Elektroden und Druckkontaktkörpern ist im Hinblick auf die mechanische Belastung auch für die randseitige Dichtung günstig.

Die Erfindung wird nachfolgend anhand eines in der Zeichnung dargestellten Ausführungsbeispieles näher erläutert. Es zeigt

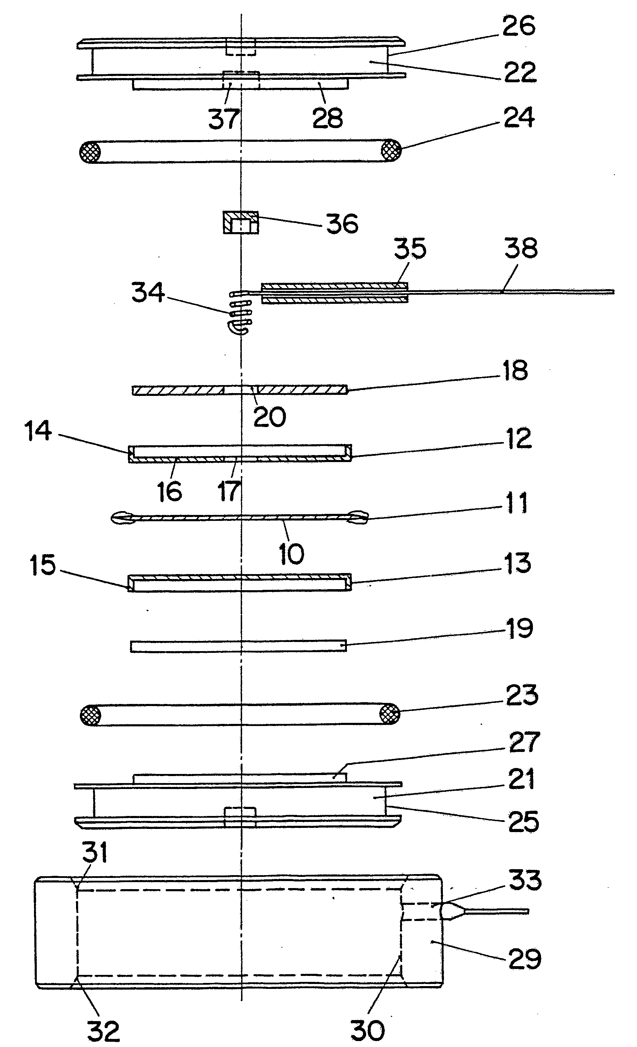

Fig. 1 eine Explosionszeichnung des Halbleiterbauelementes und

Fig. 2 das Halbleiterbauelement im zusammengebauten Zustand.

Im Ausführungsbeispiel ist ein Thyristor dargestellt.

Wesentlicher Bestandteil der Gesamtanordnung ist zunächst ein scheibenförmiger Halbleiterkörper 10, der randseitig doppelt angeschrägt und mit einer Passivierungsschicht 11 versehen sein kann. Jeweils von einer Hauptoberfläche des Halbleiterkörpers aus betrachtet, folgen:

a) Eine napfförmige Elektrode 12 bzw. 13 aus duktilem Material, vorzugsweise aus Silber, deren Napfrand 14 bzw. 15 vom Halbleiterkörper 10 abgewandt ist; und deren Boden 16 eine Durchgangsöffnung 17 für den Anschluß einer Steuerelektrode 38 aufweist.

Im dargestellten Ausführungsbeispiel besitzt nur der für die Kathodenseite des Halbleiterkörpers 10 bestimmte Silbernapf 14 eine solche Öffnung 17. Es versteht sich jedoch für steuerbare Halbleiterbauelemente, die für beide Stromrichtungen in einen Zustand höheren und einen Zustand niedrigeren Widerstandes schaltbar sind und beidseitig herausgeführte Steuerelektroden besitzen (z. B. DE-A-2 723 951), daß auch der andere Silbernapf 15 eine solche Öffnung besitzen kann:

b) Eine in den Silbernapf 14 bzw. 15 einlegbare Ronde 18 bzw. 19 aus thermisch und elektrisch leitfähigem Material, vorzugsweise Molybdän, wobei eine der beiden Ronden wieder eine Durchtrittsöffnung 20 für die Steuerelektrode 38 besitzt.

c) Ein Druckkontaktkörper 21 bzw. 22, in den eine im Ausführungsbeispiel als Dichtring 23 bzw. 24 ausgebildete Dichtungseinlage einlegbar ist. Der vorzugsweise aus Kupfer bestehende Druckkontaktkörper 21 bzw. 22 besitzt zu diesem Zweck eine Nut 25 bzw. 26. Weiterhin weist der Druckkontaktkörper 21 bzw. 22 auf seiner dem Halbleiterkörper 10 zugewandten Seite einen Tisch 27 bzw. 28 zur Zentrierung auf.

Zur randseitigen Isolierung ist ein hohlzylindrisches Isoliergehäuse 29 vorgesehen, dessen Innenwand 30 oben und unten Fasen 31 mit etwas größerem Durchmesser, als ihn die übrige Innenwand 30 aufweist, besitzt. Weiterhin ist eine Durchgangsöffnung 33 für die Steuerelektrode 38 vorhanden. Die Steuerelektrode hat auf ihrer mit dem Halbleiterkörper 10 über Druck zu kontaktierenden Seite in an sich bekannter Weise eine kleine Feder 34 (DE-A-2 246 423) und ist mit einer Isoliertülle 35 umgeben, die in die Durchführung 33 durch das Isoliergehäuse 29 paßt und die Steuerelektrode 38 mechanisch stabilisiert. Die Feder 34 bekommt zur Isolierung gegen den Druckkontaktkörper 22 einen kleinen Hut 36 aus Isoliermaterial. Der Isolierkörper 22 besitzt eine an die Hutform angepaßte Ausnehmung 37.

Der Zusammenbau des Halbleiterbauelementes geschieht in folgender Weise: Es werden Isolierringe 23 bzw. 24 verwendet, die je nach dem Material, aus dem sie bestehen, so vermaßt sind, daß der jeweilige Isolierring 23 bzw. 24 im heißen Zustand zusammen mit dem Druckkontaktkörper 21 bzw. 22 aus Kupfer eine geeignete Passung darstellt.

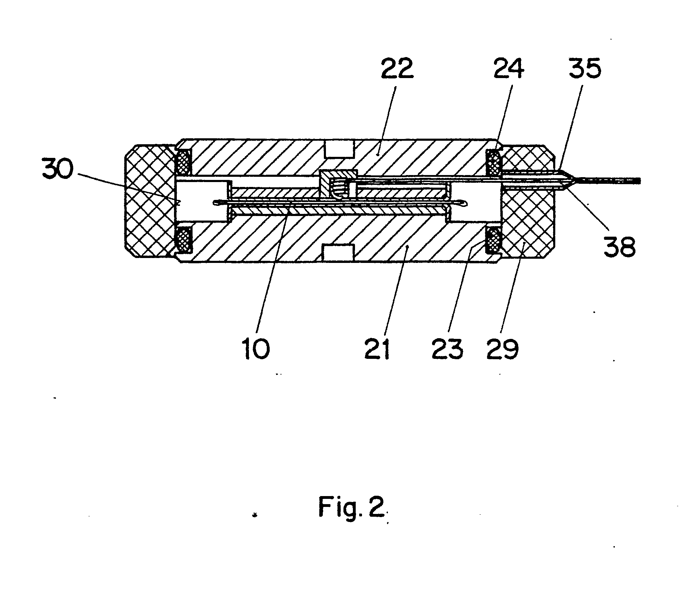

Der Dichtring 23 bzw. 24 wird in die Nut 25 bzw. 26 des Druckkontaktkörpers 21 bzw. 22 gelegt. Über die Einführungsphase 32 am Isoliergehäuse 29 wird zunächst der eine Druckkontaktkörper 21 in dasselbe bis zu seinem Boden hineingedrückt. Nacheinander und übereinander werden dann die anodenseitige Molybdänronde 19, das aus dem Halbleiterkörper 10 und den beiden Silbernäpfen 14 und 15 bestehende Sandwich, die kathodenseitige Molybdänronde 18 und die Steuerelektrodenanschlußteile 38, 34 bis 36 in das Gehäuse 29 eingebracht. Die Zentrierung dieses Gebildes geschieht über den Silbernapf 15, der über die Molybdänronde 19 hinaus den Tisch 27 am anodenseitigen Druckkontaktkörper 21 umfaßt. Das Gehäuse wird schließlich durch den Einsatz des mit dem Dichtring 24 versehenen Druckkontaktkörpers 22 so komplettiert, daß beide Druckkontaktkörper ca. 0,5 mm über die Stirnseiten des hohlzylindrischen Isoliergehäuses 29 hinausragen (Fig. 2).

Fig. 2 zeigt, daß die Dicht- bzw. O-Ringe 23 und 24 im zusammengebauten Zustand des Halbleiterbauelementes relativ großflächig zur Flächenanlage einerseits an der Innenwand 30 des Isoliergehäuses 29 und andererseits an den Druckkontaktkörper 21 und 22 gelangen.

Das hohlzylindrische Isoliergehäuse 29 kann zur weiteren Verbilligung anstelle von Aluminiumoxidkeramik aus Steatiten, glasfaserverstärkten Epoxidmassen, Glas oder ähnlichem bestehen. Als Grundmaterial für die Dichtringe 23 und 24 kann, wie bereits erwähnt, das für Wellendichtringe übliche Material gewählt werden.

Die Dichtringtechnik erfordert nur etwa 3% der Werkzeugkosten, die für die Umpreßtechnik notwendig wären.

Da jeweils der O-Ring 23, 24 nicht nur das abdichtende Element, sondern auch einen elastischen Puffer zwischen Druckkontaktkörper 21 bzw. 22 und Isoliergehäuse 29 darstellt, ist eine aufwendige Verlötung eines Blechflansches mit dem Kupfer wie bei der Umpreßtechnik nicht notwendig. Das heißt gleichzeitig, daß man für die Anschlußelektroden handelsübliches, preiswertes Kupfermaterial wie ECuF 25 verwenden kann. Im Falle der Verlötung mit einem Flansch, wie beim Gegenstand eingangs erwähnten älteren Patentanmeldung, muß nämlich Material mit sehr hoher Ausgangshärte verwendet werden, beispielsweise ZrCu, um nach dem Lötprozeß noch eine notwendige Resthärte zu erhalten.

Ein weiterer Vorteil der Dichtringtechnik besteht darin, daß im Falle eines elektrischen Ausfalls eines Halbleiterbauelementes alle Einzelteile außer dem Sandwich wiederverwendet werden können. Schließlich ist die Montage bei der Dichtringtechnik einfacher und erfordert weniger Zeit als bei der Umpreßtechnik.

Sowohl gegenüber der Umpreßtechnik als auch gegenüber dem bisherigen Gehäuse mit Keramik-Ring ergeben sich somit erhebliche Einsparungen.

Weiterhin weist das in Dichtringtechnik hergestellte Halbleiterbauelement eine hohe Dichtigkeit auf mit einer von beispielsweise unter

$$10^{-3} \frac{\text{Torr} \cdot \text{ltr}}{\text{sec}}.$$

Umpreßgehäuse erweisen sich dagegen oft am Übergang Blech/Umpreßmasse als undicht. Das in Dichtringtechnik hergestellte Halbleiterbauelement übersteht auch Temperaturwechselbeanspruchungen, beispielsweise in einem Temperaturbereich von 223 K bis 423 K ohne Schaden.

Weiterhin sind die in Dichtringtechnik hergestellten Halbleiterbauelemente auch langzeitig resistent und in ihren elektrischen Eigenschaften weitgehend stabil unter harten Prüfbedingungen mit aggressiven Medien wie $SO_2/SO_3^{--}$, $NO_2^-$, $Cl_2/Cl^-$, $NH_3/NH_4^+$ und Öl.

## Patentansprüche

1. Halbleiterbauelement mit einem scheibenförmigen, mindestens einen pn-Übergang aufweisenden Halbleiterkörper (10), welcher an jeder seiner beiden Hauptoberflächen über zwischengelegte Elektrodenteile, dabei insbesondere eine duktile Elektrode (12, 13), und über einen vorzugsweise aus Kupfer bestehenden Druckkontaktkörper (21, 22) thermisch und elektrisch druckkontaktierbar ist, mit einem die Ränder des Halbleiterkörpers (10) und der Druckkontaktkörper (21, 22) umschließenden, zylinderringförmigen Isoliergehäuse (29) sowie mit elastischen Dichtungsringen (23, 24) zur Abdichtung des Spaltes zwischen den Druckkontaktkörpern (21, 22) und dem Isoliergehäuse (29), dadurch gekennzeichnet, daß jeder der beiden Druckkontaktkörper (21, 22) in seiner Randseite eine umlaufende Ausnehmung (25, 26) besitzt, in der sich je ein den Druckkontaktkörper (21, 22) dicht umfassender, elastischer Dichtungsring (23, 24) befindet, der an der Innenwand (30) des Isoliergehäuses (29) dichtend anliegt, und daß die mit dem gleichzeitig als elastischer Puffer wirkenden Dichtungsring (23, 24) versehenen Druckkontaktkörper (21, 22) in ihrem in das Isoliergehäuse (29) eingesetzten Zustand das Gehäuse des Halbleiterbauelements komplettieren.

2. Halbleiterbauelement nach Anspruch 1, gekennzeichnet durch Verwendung von Dichtungen aus Naturkautschuk-Vulkanisation oder aus gummiähnlichen Kunststoffen, vorzugsweise auf der Basis von Neoprenen, Thioplasten oder Siliconen.

3. Halbleiterbauelement nach Anspruch 1 oder 2, gekennzeichnet durch ein Isoliergehäuse (29) aus Steatit, glasfaserverstärkten Epoxidharzen oder Glas.

4. Halbleiterbauelement nach Anspruch 1, 2 oder 3, dadurch gekennzeichnet, daß das Isoliergehäuse (29) an seiner Innenwand (30) oben und unten Fasen (31) mit etwas größerem Durchmesser als die Innenwand (30) besitzt.

5. Halbleiterbauelement nach Anspruch 1 oder folgenden, gekennzeichnet durch Zentriereinheiten an den dem Halbleiterkörper (20) zugewandten Seiten der Druckkontaktkörper (21, 22).

6. Halbleiterbauelement nach Anspruch 1 mit zwischengelegten, napfförmigen, duktilen Elektroden, deren hochstehende Napfränder den Druckkontaktkörpern zugewandt sind, dadurch gekennzeichnet, daß jeweils der Druckkontaktkörper (21, 22) einen Tisch (27, 28) als Zentriereinrichtung aufweist, der vom Naprand (14, 15) umfaßt ist.

## Claims

1. A semiconductor device with a disc-shaped semiconductor body (10), which has at least one p-n junction and each of the two main surfaces of which may be pressure-contacted thermally and electrically by way of interposed electrode parts, in particular a ductile electrode (12, 13), and by way of a pressure-contact body (21, 22) preferably consisting of copper, with an insulating casing (29) shaped like a cylindrical ring and surrounding the edges of the semiconductor body (10) and the pressure-contact bodies (21, 22), and with resilient sealing rings (23, 24) for sealing the gap between the pressure-contact bodies (21, 22) and the insulating casing (29), characterized in that the edge face of each of the two pressure-contact bodies (21, 22) has a continuous recess (25, 26) in which there is in each case a resilient sealing ring (23, 24) which tightly surrounds the pressure-contact bodies (21, 22) and which bears in a sealing manner against the inner wall (30) of the insulating casing (29), and in the state in which they are inserted into the insulating casing (29) the pressure-contact bodies (21, 22) provided with the sealing ring (23, 24) acting at the same time as a resilient buffer complete the casing of the semiconductor device.

2. A semiconductor device according to Claim 1, characterized by the use of seals of natural rubber vulcanization or synthetic materials similar to rubber, preferably on the basis of neoprenes, thioplastics or silicones.

3. A semiconductor device according to Claim 1 or 2, characterized by an insulating casing (29) of steatite, glass-fibre-reinforced epoxy resins or glass.

4. A semiconductor device according to Claim 1, 2 or 3, characterized in that the inner wall (30) of the insulating casing (29) has chamfers (31) at the top and bottom with a somewhat greater diameter than the inner wall (30).

5. A semiconductor device according to Claim 1 or the following Claims, characterized by centering means on the sides of the pressure-contact bodies (21, 22) facing the semiconductor device (20).

6. A semiconductor device according to Claim 1 with interposed pan-shaped ductile electrodes, in which the projecting edges of the pan face towards the pressure-contact bodies, characterized in that the pressure-contact body (21, 22) is provided in each case with a raised portion (27, 28) as a centering means which is suttronded by the edge (14, 15) of the pan.

**Revendications**

1. Composant semi-conducteur comportant un corps semi-conducteur (10) en forme de disque, présentant au moins une jonction pn et qui peut être contacté sous pression, thermiquement et électriquement, sur chacune de ses deux surfaces principales par l'intermédiaire de pièces d'électrodes intercalées, en particulier une électrode ductule (12, 13), et par l'intermédiaire d'un corps de contact par pression (21, 22) constitué de préférence en cuivre; une enveloppe isolante (29) en forme d'anneau cylindrique entourant les bords du corps semi-conducteur (10) et des corps de contact par pression (21, 22), ainsi que des anneaux élastiques d'étanchéité (23, 24) pour étanchéifier l'intervalle entre les corps de contact par pression (21, 22) et l'enveloppe isolante (29), caractérisé en ce que chacun des deux corps de contact par pression (21, 22) comporte dans son côté marginal une partie périphérique en retrait (25, 26) où se trouve chaque fois un anneau d'étanchéité (23, 24) élastique entourant étroitement le corps de contact par pression (21, 22) et qui repose de façon étanche sur la paroi interne (30) de l'enveloppe isolante (29), et en ce que les corps de contact par pression (21, 22) munis de l'anneau d'étanchéité (23, 24) agissant simultanément comme coussin élastique complètent l'enveloppe du composant semi-conducteur lorsqu'ils sont introduits dans l'enveloppe isolante (29).

2. Composant semi-conducteur selon la revendication 1, caractérisé par l'emploi de dispositifs d'étanchéité en vulcanisat de caoutchouc naturel ou en matière plastique du type caoutchouc, de préférence à base de néoprènes, thioplastes ou silicones.

3. Composant semi-conducteur selon la revendication 1 ou 2, caractérisé par une enveloppe isolante (29) en stéatites, résines époxyde renvorcées par des fibres de verre ou bien verre.

4. Composant semi-conducteur selon la revendication 1, 2 ou 3, caractérisé en ce que l'enveloppe isolante (29) présente sur sa paroi interne (30) en haut et en bas des biseaux (31) ayant un diamètre un peu plus grand que la paroi interne (30).

5. Composant semi-conducteur selon l'une des revendications précédentes, caractérisé par des unités de centrage sur les côtés des corps de contact par pression (21, 22) tournés vers le corps semi-conducteur (20).

6. Composant semi-conducteur selon la revendication 1, comportant des électrodes ductiles en forme de cuvette intercalées dont les bords de cuvette hauts sont tournés vers les corps de contact par pression, caractérisé en ce que le corps de contact par pression (21, 22) présente respectivement comme dispositif de centrage une table (27, 28) qui est entourée par le bord de cuvette (14, 15).

0 016 768

-1-

Fig. 2